# DEMANDE DE BREVET EUROPEEN

(11) **EP 4 750 274 A1**
(43) Date de publication de la demande: **27.05.2026**
(21) Numéro de dépôt: 25216399.3
(22) Date de dépôt: 17.11.2025
(51) Int. Cl.: H10F 71/00, H10F 19/90

(54) **PROCÉDÉ DE FABRICATION D'UNE CHAÎNE DE CELLULES PHOTOVOLTAÏQUES**

(30) Priorité: 22.11.2024 FR 2412808
(71) Demandeur: Commissariat à l'Énergie Atomique et aux Énergies Alternatives, 75015 Paris (FR)
(72) Inventeur: DESRUES, Thibaut, 38054 GRENOBLE (FR); HARRISON, Samuel, 38054 GRENOBLE (FR); BARTH, Vincent, 38054 GRENOBLE (FR)
(74) Mandataire: Ipsilon

(57) **Abrégé**

Procédé de fabrication d'une chaîne photovoltaïque, comportant les étapes suivantes :
(a) fournir un assemblage de sous-cellules (10) disposées en tuiles selon des lignes de tuilage (11) parallèles entre elles, les sous-cellules étant connectées entre elles en série,
(b) découper l'assemblage perpendiculairement aux lignes de tuilage (11) pour obtenir plusieurs bandes (20) de sous-cellules disposées en tuiles,
(c) connecter entre elles les bandes (20) de sous-cellules obtenues.

## Description

### Domaine technique

La présente invention concerne la fabrication de chaînes (« *string* » en anglais) de cellules photovoltaïques destinées à former des modules photovoltaïques. Elle s'applique en particulier aux chaînes de cellules photovoltaïques résultant de l'assemblage de sous-cellules photovoltaïques, obtenues à partir de plaquettes de matériau semi-conducteur, par exemple du silicium cristallin, et vise plus particulièrement un procédé pour permettre la fabrication de chaînes photovoltaïques avec plusieurs bandes de sous-cellules.

### Technique antérieure

Classiquement, une cellule photovoltaïque comporte une plaquette, communément dénommée « *wafer* » en anglais, qui présente une forme de pavé droit de faible épaisseur. La plaquette est composée d'un matériau semi-conducteur, généralement du silicium.

On peut, pour certaines applications, être amené à vouloir découper une telle plaquette en plusieurs sous-cellules.

Une application particulière concerne la fabrication de cellules photovoltaïques selon un agencement particulier en tuilage, de type appelé (« *shingle »* en anglais) présenté par exemple dans le document US 2017/0077343°Al. Dans un tel agencement, des sous-cellules sont superposées de sorte à se chevaucher partiellement entre elles, ce qui permet d'assurer une connexion mécanique ainsi qu'une connexion électrique d'une sous-cellule à l'autre à l'endroit où elles se chevauchent partiellement. Une telle méthode d'assemblage en tuilage (*« shingling »* en anglais), permet de réduire les pertes résistives et d'obtenir un gain en puissance sur le module photovoltaïque dans lequel sont placées les cellules photovoltaïques.

Les sous-cellules sont typiquement obtenues en effectuant une découpe d'une plaque (*wafer*) sur laquelle leurs éléments constitutifs ont été au moins partiellement réalisés et de préférence une fois que leurs éléments constitutifs ont été entièrement fabriqués. On n'a ici pas besoin de modifier l'intégralité d'une ligne de fabrication de cellules mais seulement de réaliser une ou plusieurs étapes supplémentaires, ce qui présente un avantage important en termes de coût de fabrication.

Le document US 2024/007049 divulgue une bande de cellules photovoltaïque à haute puissance disposées en tuiles contrôlable en longueur et en largeur et sa méthode de fabrication. La longueur et la largeur sont contrôlées avec des étapes de creusement de lignes sur la surface du substrat.

Le document KR 102504524 B1 divulgue un panneau solaire semi-transparent en tuiles fabriqué en formant un groupe de bandes en tuiles et en les collant avec un ruban métallique. Les bandes en tuiles son espacées pour permettre le passage de la lumière.

Cependant, de telles cellules photovoltaïques en tuilage peuvent présenter des difficultés de manipulation, du fait de la taille réduite des sous-cellules.

Il existe donc un besoin pour améliorer encore les cellules photovoltaïques, aussi bien en ce qui concerne leur manipulation que leurs performances, notamment pour permettre leur utilisation dans un module photovoltaïque à haute tension.

La présente invention vise à répondre à ce besoin.

### Exposé de l'invention

L'invention a ainsi pour objet, selon l'un de ses aspects, un procédé de fabrication d'une chaîne photovoltaïque, comportant les étapes suivantes :
(a) fournir un assemblage de sous-cellules disposées en tuiles selon des lignes de tuilage parallèles entre elles, les sous-cellules étant connectées entre elles en série,
(b) découper l'assemblage perpendiculairement aux lignes de tuilage pour obtenir plusieurs bandes de sous-cellules disposées en tuiles,
(c) connecter entre elles les bandes de sous-cellules obtenues.

Une chaine photovoltaïque résulte de l'assemblage de sous-cellules photovoltaïques, obtenues à partir d'une ou plusieurs plaquettes de matériau semi-conducteur, par exemple du silicium cristallin. Une chaîne photovoltaïque est formée par la pluralité de bandes de sous-cellules connectées entre elles en série, les bandes de sous-cellules étant notamment connectées en série ou en parallèle.

Un module photovoltaïque peut être formé d'une pluralité de sous-cellules connectées entre elles, formant des chaines photovoltaïques et en général encapsulées entre deux couches de protection.

Les étapes (a), (b) et (c) peuvent avoir lieu dans l'ordre indiqué. L'étape (b) de découpe peut en particulier être réalisée après l'étape (a).

Le découpage de l'assemblage permet d'obtenir au moins deux bandes de sous-cellules. Ainsi, l'assemblage initial est découpé à deux reprises, une première fois avant le tuilage, pour former les sous-cellules à tuiler, et une deuxième fois après le tuilage, pour former les bandes de sous-cellules à connecter. Le procédé selon l'invention comporte une étape de découpe (b) après le tuilage.

La mise en œuvre de la découpe des bandes de sous-cellules après le tuilage permet de manipuler des bandes de sous-cellules comportant chacune une pluralité de sous-cellules assemblées par tuilage, autrement dit de plus grande taille que des sous-cellules seules. Cela facilite la manipulation et permet d'améliorer la qualité de fabrication.

On découpe à l'étape (b) perpendiculairement aux lignes de tuilage, c'est-à-dire perpendiculairement à la limite entre deux sous-cellules.

Par 'ligne de tuilage', on entend l'axe longitudinal de chevauchement entre deux sous-cellules adjacentes disposées en tuiles.

Les bandes de sous-cellules peuvent être connectées entre elles en série ou en parallèle.

L'invention permet de bénéficier de chaînes de cellules photovoltaïques pouvant être utilisées dans des modules photovoltaïques à haute tension.

En effet, on bénéficie d'une part des avantages de l'interconnexion par tuilage, qui permet de supprimer les espacements entre cellules ou sous-cellules, d'éviter l'utilisation de rubans d'interconnexion. Cela permet de diminuer les pertes résistives et d'augmenter la tension de sortie du module photovoltaïque correspondant sans avoir à en augmenter la taille. En particulier, la tension de sortie peut être multipliée par le nombre de sous-cellules disposées en tuiles.

D'autre part, la présence de bandes de sous-cellules connectées entre elles en série ou en parallèle permet plus de variation dans les interconnexions entre bandes de sous-cellules, ce qui peut permettre d'individualiser les bandes de sous-cellules et de rendre le module photovoltaïque plus résilient à l'ombrage.

En outre, la tension de sortie peut être multipliée par le nombre de bandes de sous-cellules.

Une bande de sous-cellules peut comporter par exemple entre 2 et 200 sous-cellules, voire entre 3 et 100, voire encore entre 4 et 80, par exemple entre 5 et 70, par exemple 6 sous-cellules ou encore en variante 30 sous-cellules.

Les modules photovoltaïques à haute tension sont avantageux pour certaines applications particulières, par exemple pour certaines applications terrestres ou extraterrestres, telles que des applications embarquées, notamment automobiles ou spatiales, notamment pour des applications pour lesquelles la taille et/ou le poids du module peut être limitée. On peut obtenir des hautes tensions même sur des petites surfaces de module.

Les sous-cellules peuvent être obtenues par découpage d'une plaquette. Par « plaquette », autrement dénommée « *wafer* » en anglais, on désigne un substrat ayant une forme de pavé droit de faible épaisseur, formé à partir d'un matériau semi-conducteur, généralement du silicium et plus particulièrement du silicium cristallin. L'épaisseur de la plaquette peut être comprise entre 100 et 400 µm, par exemple de l'ordre de 180 µm.

Les plaquettes peuvent être de taille standard ou résulter du découpage de plaquettes de taille standard. Par exemple, les plaquettes peuvent résulter du découpage en 2, en 3, en 4, ou en 6 ou plus d'une plaquette de taille standard. Une plaquette de taille standard peut être carrée ou sensiblement carrée. Elle peut avoir un côté de longueur choisie dans la liste suivante, en millimètres (mm) : 210, 200, 192, 166, 161,7, 158,75, 156,75, cette liste n'étant pas limitative.

L'étape (a) de fourniture de l'assemblage de sous-cellules disposées en tuiles selon des lignes de tuilage parallèles entre elles, les sous-cellules étant connectées entre elles en série, peut comporter les étapes suivantes :
(a1) fournir une plaquette de matériau semi-conducteur,
(a2) tracer des lignes conductrices d'interconnexion parallèles entre elles,
(a3) découper les sous-cellules parallèlement aux lignes conductrices d'interconnexion,
(a4) assembler les sous-cellules en tuiles.

Les étapes (a1), (a2), (a3) et (a4) peuvent avoir lieu dans l'ordre indiqué. L'étape (a3) peut avoir lieu après l'étape (a2).

### Résumé de l'invention

### Lignes conductrices

L'assemblage peut comporter plusieurs lignes conductrices d'interconnexion parallèles entre elles, destinées à permettre 1a conduction d'un courant électrique photo-généré dans le matériau semi-conducteur. Lors de l'étape (b) de découpe, on peut découper l'assemblage perpendiculairement aux lignes conductrices d'interconnexion.

Chaque sous-cellule peut comporter une ligne conductrice d'interconnexion sur au moins une de ses faces. Une ligne conductrice d'interconnexion peut être disposée sur un côté d'une sous-cellule, notamment une grand côté de la sous-cellule, et s'étendre parallèlement à un bord de la sous-cellule. Cette ligne conductrice d'interconnexion est configurée pour permettre l'interconnexion électrique de la sous-cellule correspondante avec une autre ou les autres sous-cellules. Une ligne conductrice d'interconnexion peut avoir une largeur comprise entre 50 µm et 500 µm, voire comprise entre 100 µm et 400 µm, Elle peut se présenter sous forme continue (ligne) ou discontinue (plots).

Chaque sous-cellule peut comporter en outre des doigts de métallisation. Par 'doigt de métallisation', on entend des lignes conductrices destinées à conduire le courant électrique photo-généré dans le matériau semi-conducteur vers une ligne conductrice d'interconnexion.

La conduction peut être directe vers une ligne conductrice d'interconnexion, les doigts de métallisation pouvant alors s'étendre perpendiculairement aux lignes conductrices d'interconnexion, ou indirecte, se faisant en passant par une ligne conductrice de collecte telle que décrite ci-après, les doigts de métallisation pouvant alors s'étendre perpendiculairement aux lignes conductrices de collecte et parallèlement aux lignes conductrices d'interconnexion.

Une sous-cellule peut comporter une pluralité de doigts de métallisation, par exemple entre 5 et 100, voire entre 10 et 80, voire encore entre 15 et 60, par exemple entre 20 et 40. On peut avoir un doigt de métallisation tous les 1 à 3 mm, voire tous les 2 mm. Un doigt de métallisation peut avoir une largeur comprise entre 10 µm et 80 µm, voire comprise entre 15 µm et 50 µm, voire encore comprise entre 15 µm et 30 µm. Un doigt de métallisation peut avoir une longueur inférieure à 4 cm, voire inférieure à 3,5 cm, mieux inférieure à 3 cm, étant par exemple de 2,6 cm. Ainsi, la distance à parcourir par le courant dans un doigt de métallisation est relativement faible, ce qui est avantageux compte tenu des pertes qui dépendent de la distance au carré.

Chaque sous-cellule peut comporter en outre des lignes conductrices de collecte. Par 'lignes conductrices de collecte', on entend des lignes conductrices destinées à conduire le courant électrique photo-généré dans le matériau semi-conducteur depuis les doigts de métallisation vers une ligne conductrice d'interconnexion. Les lignes conductrices de collecte peuvent s'étendre perpendiculairement aux lignes conductrices d'interconnexion et perpendiculairement aux doigts de métallisation. Chaque sous-cellule peut comporter des lignes conductrices de collecte, destinées à conduire le courant électrique photo-généré dans le matériau semi-conducteur vers une ligne conductrice d'interconnexion.

Les lignes conductrices de collecte peuvent être particulièrement utile lorsque la largeur de la sous-cellule est supérieure à 2 cm, voire supérieure à 3 cm. Cette configuration avec des lignes conductrices de collecte permet de travailler avec des largeurs de sous-cellules plus grandes sans augmenter les pertes résistives.

Une sous-cellule peut comporter une pluralité de lignes conductrices de collecte, par exemple entre 2 et 20, voire entre 3 et 17, voire encore entre 4 et 15, par exemple entre 5 et 12. On peut par exemple avoir une lignes conductrices de collecte tous les 4 cm, voire tous les 5 cm.

### Bandes de sous-cellules

Les sous-cellules peuvent être interconnectées entre elles par exemple par collage, notamment par un adhésif conducteur d'électricité (dit ECA). Entre deux sous-cellules consécutives, on a donc une portion comportant deux épaisseurs de matériau semi-conducteur et une épaisseur d'adhésif, par exemple d'ECA. En variante, les sous-cellules peuvent être interconnectées entre elles par exemple par soudure ou encore par l'utilisation de connecteur souples et/ou flexibles.

Le découpage des sous-cellules peut être effectué par l'un au moins des procédés de découpe de la liste suivante, qui n'est pas limitative : LSMC (Gravure laser et clivage mécanique, en anglais *'Laser scribe and mechanical cleaving'*), TLS (Séparation laser thermique, en anglais '*Thermal laser separation'*), découpe par clivage mécanique sur des plaquettes orientées à 45° (également appelé en anglais *'45° tilted silicon wafers'*).

Le découpage (b) de l'assemblage en bandes de sous-cellules peut être effectué par l'un au moins des procédés de découpe de la liste suivante, qui n'est pas limitative : LSMC (Gravure laser et clivage mécanique, en anglais *'Laser scribe and mechanical cleaving'*), TLS (Séparation laser thermique, en anglais '*Thermal laser separation'*), découpe par clivage mécanique sur des plaquettes orientées à 45° (également appelé en anglais '*45*° *tilted silicon wafers'*).

On peut utiliser un procédé de découpe, notamment laser, permettant de s'adapter à la disposition des sous-cellules en tuiles. Le procédé de découpe peut également être adapté à la technologie des cellules photovoltaïques. Le choix des caractéristiques du laser utilisé peut également être adapté. Il peut être choisi de manière à minimiser les zones gravées et afin de limiter les dégradations de performances des cellules photovoltaïques résultantes.

La métallisation de l'assemblage ou des sous-cellules peut également être adaptée. On peut notamment former les lignes conductrices d'interconnexion et/ou de collecte en évitant toute métallisation dans les zones de découpe. On peut également éviter tout dépôt d'adhésif électriquement conducteur dans les zones de découpe.

Dans le procédé de LSMC (Gravure laser et clivage mécanique, en anglais *'Laser scribe and mechanical cleaving'*), on peut réaliser une amorce sur la face arrière, puis une découpe et l'étape de clivage sur la face avant. On peut réaliser une amorce sur la face opposée à l'émetteur de la cellule, généralement sur la face arrière. On cherche à limiter les gravures du côté de l'émetteur, donc en face arrière si l'émetteur est disposé en face arrière. Dans un mode de réalisation, la largeur de l'amorce peut être supérieure ou égale à la largeur de recouvrement entre sous-cellules tuilées. En variante, la largeur des amorces peut être plus fines.

Dans le procédé de TLS (Séparation laser thermique, en anglais *'Thermal laser separation*')*,* on peut réaliser une amorce sur la face arrière, puis une amorce sur la face avant et enfin la séparation en face avant. Dans ce procédé de découpe, on ne réalise pas de découpe avec trait continu. L'amorce se propage en raison de contraintes thermomécaniques le long le d'une ligne. Dans un mode de réalisation, la largeur de l'amorce peut être supérieure ou égale à la largeur de recouvrement entre sous-cellules tuilées. En variante, la largeur des amorces peut être plus fines.

Dans le procédé de découpe par clivage mécanique (également appelé en anglais '*45*° *tilted silicon wafers'*), on peut réaliser une amorce sur la face arrière, puis un clivage sur la face arrière. La séparation résulte des contraintes mécaniques exercées de chaque côté lors du clivage. L'amorce peut se propager du fait d'une orientation cristalline particulière dans l'assemblage.

### Amorce

L'étape de découpage (b) de l'assemblage en bandes de cellules peut comporter la formation d'une amorce. Par 'amorce', on entend la réalisation d'un trait en creux, localisé ou continu. L'amorce peut être localisée ou continue.

L'amorce peut être réalisée sur la face arrière ou en variante ou additionnellement sur la face avant. Par 'face avant', on entend la face de la cellule photovoltaïque destinée à être exposée à la lumière pour recevoir les photons. Par 'face arrière', on entend la face opposée à la face avant.

Dans le cas où l'émetteur est disposé en face arrière, la face avant est le côté non émetteur de la cellule photovoltaïque. La face arrière est le côté émetteur de la cellule photovoltaïque.

Dans le cas où l'émetteur est disposé en face avant, la face arrière est le côté non émetteur de la cellule photovoltaïque. La face avant est le côté émetteur de la cellule photovoltaïque

Dans la plupart des cas, on va réaliser cette amorce sur la face opposée à l'émetteur de la cellule, donc classiquement sur la face arrière.

L'amorce peut être réalisée sur une première portion de l'assemblage comportant une double épaisseur, résultant du tuilage des sous-cellules.

L'amorce peut être réalisée sur une deuxième portion de l'assemblage disposée à une extrémité de l'assemblage. Il peut s'agir d'une première extrémité de l'assemblage ou d'une deuxième extrémité, ou à la fois une première extrémité et une deuxième extrémité. L'amorce peut être réalisée substantiellement perpendiculairement aux lignes de tuilage. Elle peut être réalisée attenante à un bord libre de l'assemblage.

L'amorce peut avoir une profondeur supérieure à 10 µm, voire supérieure à 20 µm, voire encore supérieure à 30 µm. La largeur de l'amorce peut être comprise entre 5 µm et 50 µm, voire comprise entre 10 µm et 30 µm.

L'amorce peut avoir, notamment pour les procédés LSMC et TLS, une longueur comprise entre 0,8 et 1,5 mm. L'amorce peut avoir, notamment pour le procédé de découpe par clivage mécanique, une longueur comprise entre 100 µm et 1 mm, voire entre 200 µm et 800 µm.

L'amorce peut être formée sur le bord d'une sous-cellule. Ainsi, une amorce est généralement formée au niveau d'une surépaisseur de l'assemblage, dans une portion de l'assemblage comportant deux épaisseurs de matériau semi-conducteur et une épaisseur d'adhésif. On peut notamment réaliser une pluralité d'amorces sur le bord de chaque sous-cellule. Les amorces réalisées peuvent être alignées entre elles, par exemple selon une ligne d'amorçage.

La ou les amorces peuvent être formées du côté de la face arrière. Dans un mode de réalisation, on forme la ou les amorces de préférence du côté de la face arrière, et on forme la découpe du côté de la face avant, qui est le côté non émetteur. Ainsi, on évite de former la découpe la plus importante du côté de l'émetteur. Dans un mode de réalisation comportant des amorces réalisées successivement des deux côtés, on réalise les premières amorces du côté de la face arrière, et on forme les deuxièmes amorces du côté de la face avant.

L'étape de découpage (b) de l'assemblage en bandes de cellules peut comporter l'application d'une contrainte, notamment une contrainte appliquée uniformément sur tout l'assemblage.

### Sous-cellule

Un rapport P/S d'une sous-cellule peut être inférieur à 2 cm-1, voire inférieur à 1,8 cm-1, voire encore inférieur à 1,6 cm-1, mieux inférieur à 1,4 cm-1, étant notamment inférieur à 1,2 ou à 1 cm-1,
où P est le périmètre de la sous-cellule et S l'aire de la sous-cellule.

Un rapport P/S de chaque sous-cellule de la chaîne photovoltaïque peut être inférieur à 2 cm-1, voire inférieur à 1,8 cm-1, voire encore inférieur à 1,6 cm-1, mieux inférieur à 1,4 cm-1, étant notamment inférieur à 1,2 ou à 1 cm-1, où P est le périmètre de la sous-cellule et S l'aire de la sous-cellule.

Un faible rapport P/S permet d'assurer que les sous-cellules ont une forme relativement carrée plutôt que très oblongue. Ainsi, les surfaces des bords dépassivées sont avantageusement diminuées, ce qui fournit un meilleur rendement. On peut également en complément utiliser des techniques de passivation des bords.

### Chaîne photovoltaïque

L'invention a encore pour objet, indépendamment ou en combinaison avec ce qui précède, une chaîne photovoltaïque comportant
une pluralité de sous-cellules disposées en tuiles,
un rapport P/S d'une sous-cellule étant inférieur à 2 cm-1, voire inférieur à 1,8 cm-1, voire encore inférieur à 1,6 cm-1, mieux inférieur à 1,4 cm-1, étant notamment inférieur à 1,2 ou à 1 cm-1,
où P est le périmètre de la sous-cellule et S l'aire de la sous-cellule.

Un rapport P/S de chaque sous-cellule de la chaîne photovoltaïque peut être inférieur à 2 cm-1, voire inférieur à 1,8 cm-1, voire encore inférieur à 1,6 cm-1, mieux inférieur à 1,4 cm-1, étant notamment inférieur à 1,2 ou à 1 cm-1, où P est le périmètre de la sous-cellule et S l'aire de la sous-cellule.

Un faible rapport P/S permet d'assurer que les sous-cellules ont une forme relativement carrée plutôt que très oblongue. Ainsi, les surfaces de bord non passivées sont avantageusement diminuées, ce qui fournit un meilleur rendement.

La chaîne photovoltaïque peut comporter au moins deux bandes de sous-cellules connectées entre elles. Grâce aux bandes de sous-cellules, la manipulation lors de la fabrication est facilitée.

La chaîne photovoltaïque, les sous-cellules et les bandes de sous-cellules peuvent comporter tout ou partie des caractéristiques décrites ci-dessus.

La chaîne photovoltaïque peut être fabriquée au moyen du procédé décrit ci-dessus.

L'invention concerne tout type de cellule photovoltaïque, tel que par exemple cellule à silicium cristallin, cellule à hétérojonction, cellule TOPCon, cellule à structure multijonction, cellule tandem Pérovskite/silicium, cette liste n'étant pas limitative.

L'invention a encore pour objet, indépendamment ou en combinaison avec ce qui précède, un module photovoltaïque comportant des chaîne photovoltaïques, des sous-cellules et/ou des bandes de sous-cellules telles que décrites ci-dessus.

### Brève description des dessins

L'invention pourra être mieux comprise à la lecture de la description détaillée qui va suivre, d'exemples de réalisation non limitatifs de celle-ci, et à l'examen du dessin annexé, sur lequel :
[Fig 1a] La figure 1a est une vue de dessus, schématique et partielle, d'un module photovoltaïque comportant des chaînes photovoltaïques et des sous-cellules photovoltaïques selon l'invention.
[Fig 1b] La figure 1b illustre une sous-cellule du module de la figure 1a.
[Fig 2a] La figure 2a est une vue de dessus, schématique et partielle, d'un module photovoltaïque comportant des chaînes photovoltaïques et des sous-cellules photovoltaïques selon l'invention.
[Fig 2b] La figure 2b illustre la fabrication de bandes de sous-cellule du module de la figure 2a.
[Fig 3] La figure 3 illustre le procédé de fabrication selon l'invention.
[Fig 4] La figure 4 illustre les lignes conductrice d'une sous-cellule.
[Fig 5a] La figure 5a illustre la réalisation d'amorces.
[Fig 5b] La figure 5b illustre une variante de réalisation d'amorces.
[Fig 6a] La figure 6a illustre une variante de réalisation de l'étape de découpe.
[Fig 6b] La figure 6b illustre une autre variante de réalisation de l'étape de découpe.
[Fig 6c] La figure 6c illustre une autre variante de réalisation de l'étape de découpe.

### Description détaillée

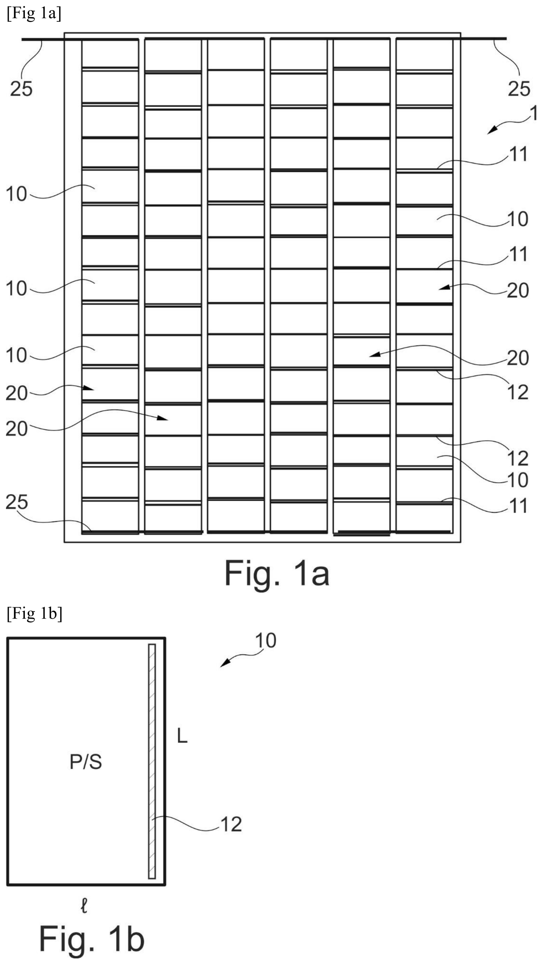

On a illustré à la figure 1a un module photovoltaïque 1 réalisé au moyen du procédé de fabrication de l'invention.

Le module photovoltaïque comporte un assemblage de sous-cellules photovoltaïques 10 disposées en tuiles, selon des lignes de tuilage 11 parallèles entre elles, les sous-cellules étant connectées entre elles en série. Une sous-cellule photovoltaïque 10 est illustrée isolément à la figure 1b, les sous-cellules étant formées à partir d'une plaquette de matériau semi-conducteur.

L'assemblage comporte plusieurs lignes conductrices d'interconnexion 12 parallèles entre elles, destinées à permettre 1a conduction d'un courant électrique photo-généré dans le matériau semi-conducteur.

On a découpé l'assemblage perpendiculairement aux lignes de tuilage 11 pour obtenir plusieurs bande de sous-cellules 20 disposées en tuiles, puis on a connecté entre elles les bandes de sous-cellules 20 obtenues, au moyen de connecteurs 25. La manipulation des bandes 20 de sous-cellules assemblées par tuilage permet de manipuler un nombre réduit de sous cellules durant le tuilage, facilitant ainsi la réalisation de cette étape.

On voit sur la figure 1a que la présence de bandes 20 de sous-cellules connectées entre elles permet d'obtenir plus d'interconnexions entre bandes de sous-cellules, ce qui peut permettre de rendre le module photovoltaïque plus résilient à l'ombrage.

En outre, la tension de sortie peut être multipliée par le nombre de bandes de sous-cellules.

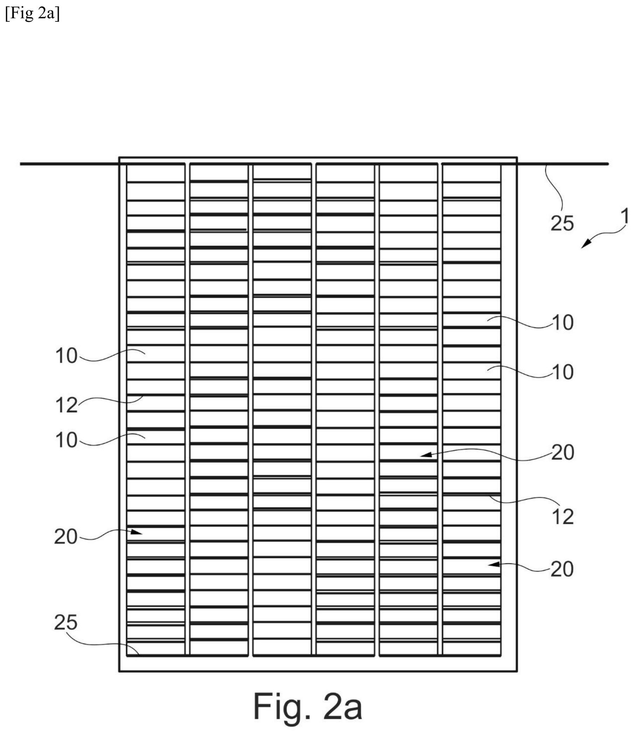

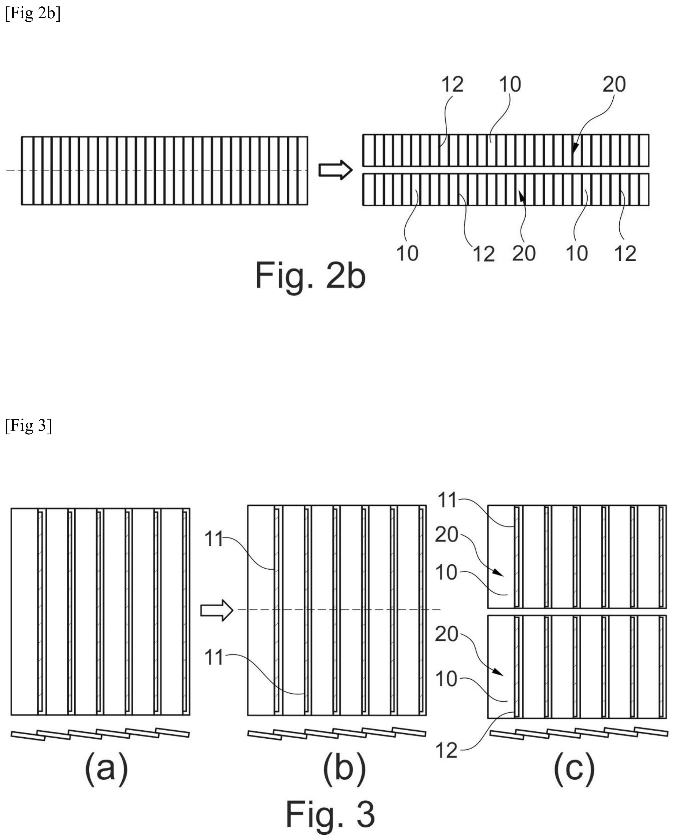

Une bande de sous-cellules peut comporter par exemple 15 sous-cellules, comme illustré à la figure 1a, ou encore en variante 30 sous-cellules, comme illustré dans le mode de réalisation des figures 2a et 2b.

Dans le procédé selon l'invention, illustré à la figure 3, on fournit à l'étape (a) un assemblage de sous-cellules 10 disposées en tuiles selon des lignes de tuilage 11 parallèles entre elles, les sous-cellules étant connectées entre elles en série. L'assemblage comporte plusieurs lignes conductrices d'interconnexion 12 parallèles entre elles, destinées à permettre la conduction d'un courant électrique photo-généré dans le matériau semi-conducteur. Ensuite, on découpe à l'étape (b) l'assemblage perpendiculairement aux lignes de tuilage 11 pour obtenir deux bandes 20 de sous-cellules disposées en tuiles, puis on vient connecter entre elles à l'étape (c) les bandes de sous-cellules obtenues.

Par ailleurs, un rapport P/S d'une sous-cellule 10 peut être inférieur à 1 cm-1, étant par exemple dans l'exemple illustré à la figure 1b de l'ordre de 0,66 cm-1. P est le périmètre de la sous-cellule et S l'aire de la sous-cellule 10. Dans cet exemple, une longueur L de la sous-cellule est de 7,2 cm et une largeur 1 de la sous-cellule est de 5,2 cm.

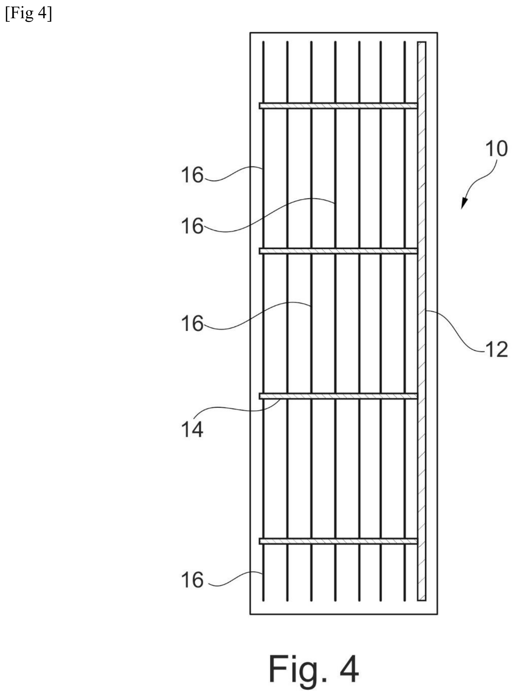

En outre, la sous-cellule 10 illustré à la figure 1b comporte une unique ligne conductrice d'interconnexion 12, laquelle est disposée sur un grand côté de la sous-cellule 10, et s'étend parallèlement à un bord de la sous-cellule, comme illustré à la figure 1b ou à la figure 4. La ligne conductrice d'interconnexion 12, appelée *'bus-bar'* en anglais, est configurée pour permettre l'interconnexion électrique de la sous-cellule 10 correspondante avec les autres sous-cellules.

Par ailleurs, chaque sous-cellule 10 comporte des doigts de métallisation non visibles sur les figures 1a à 3, destinés à conduire le courant électrique photo-généré dans le matériau semi-conducteur vers les lignes conductrices d'interconnexion 12, les doigts de métallisation s'étendant perpendiculairement aux lignes conductrices d'interconnexion 12. La sous-cellule 10 comporte ainsi une pluralité de doigts de métallisation.

Dans la variante de la figure 4, chaque sous-cellule 10 comporte des lignes conductrices de collecte 14, destinées à conduire le courant électrique photo-généré dans le matériau semi-conducteur depuis des doigts de métallisation 16 vers la ligne conductrice d'interconnexion 12, lesquelles s'étendent perpendiculairement à la ligne conductrice d'interconnexion 12. Dans cet exemple, la sous-cellule 10 comporte quatre lignes conductrices de collecte 14.

Les doigts de métallisation 16, destinés à conduire le courant électrique photo-généré dans le matériau semi-conducteur vers les lignes conductrices de collecte 14, s'étendent perpendiculairement aux lignes conductrices de collecte et parallèlement aux lignes conductrices d'interconnexion 12. La sous-cellule 10 comporte ici une pluralité de doigts de métallisation. Un doigt de métallisation a dans cet exemple une longueur de l'ordre de 2,6 cm.

Les sous-cellules tuilées sont maintenues entre elles par collage, par un adhésif conducteur d'électricité (dit ECA). Entre deux sous-cellules consécutives, on a donc une portion comportant deux épaisseurs de matériau semi-conducteur et une épaisseur d'adhésif. En variante, les sous-cellules peuvent être interconnectées entre elles par exemple par soudure ou encore par l'utilisation de connecteur souples et/ou flexibles.

Le découpage des sous-cellules 10 peut être effectué par l'un au moins des procédés de découpe de la liste suivante, qui n'est pas limitative : LSMC, TLS, découpe par clivage mécanique de plaquettes orientées à 45°.

La métallisation de l'assemblage ou des sous-cellules peut également être adaptée. On peut notamment former les lignes conductrices d'interconnexion 12 et/ou de collecte 14 en évitant toute métallisation dans les zones de découpe ultérieure. On peut également éviter tout dépôt d'adhésif électriquement conducteur dans les zones de découpe ultérieure.

Le découpage à l'étape (b) de l'assemblage en bandes 20 de sous-cellules peut être effectué par l'un au moins des procédés de découpe de la liste suivante, qui n'est pas limitative : LSMC, TLS, découpe par clivage mécanique.

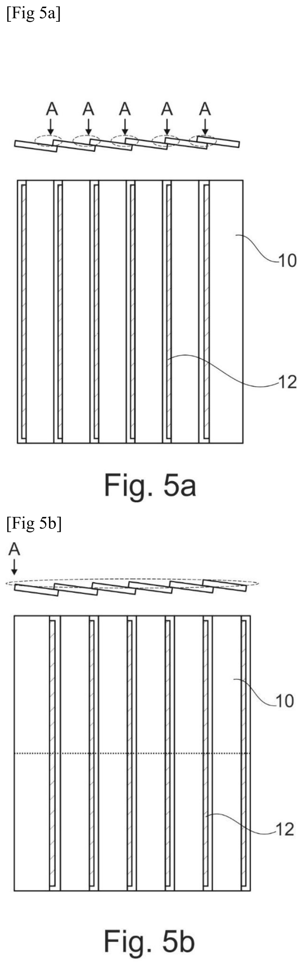

L'étape de découpage (b) de l'assemblage en bandes de sous-cellules comporte en général la formation d'une amorce A. L'amorce est un trait en creux, localisé ou continu. L'amorce A peut être localisée, comme illustré à la figure 5a, ou continue, comme illustré à la figure 5b. L'amorce A est le plus souvent réalisée sur la portion de l'assemblage comportant une double épaisseur, résultant du tuilage des sous-cellules, étant formée sur le bord de la sous-cellule. L'amorce peut être réalisée sur la face arrière ou en variante ou additionnellement sur la face avant. On peut notamment réaliser une pluralité d'amorces A sur le bord de chaque sous-cellule 10. Les amorces réalisées peuvent être alignées entre elles, par exemple selon une ligne d'amorçage, comme illustré à la figure 5a.

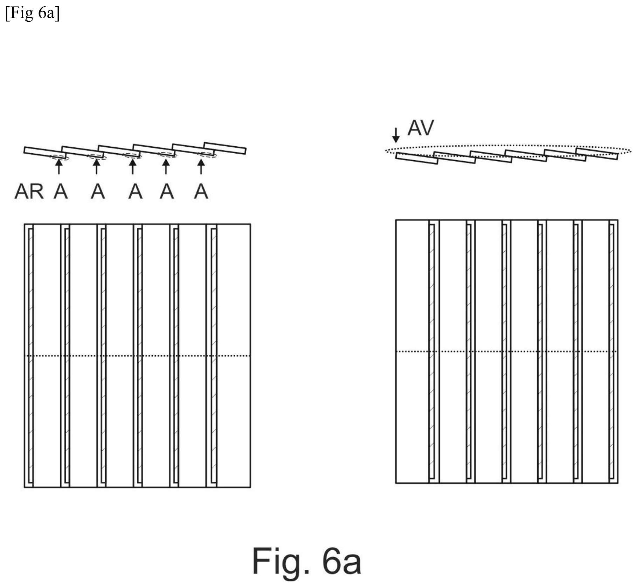

On a illustré à la figure 6a le procédé de gravure laser et clivage mécanique (LSMC), dans lequel on vient d'abord réaliser des amorces A sur la face arrière AR, puis une découpe et l'étape de clivage sur la face avant AV.

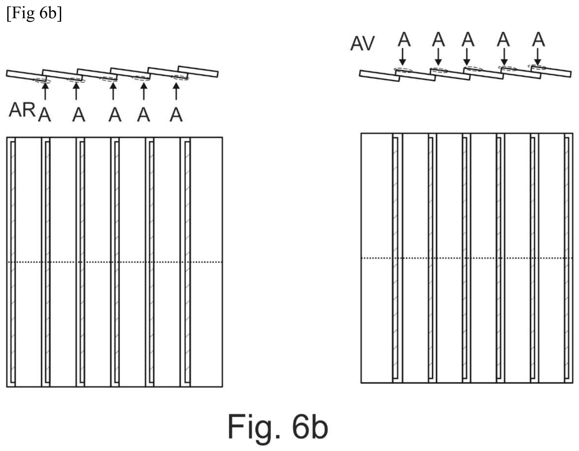

On a illustré à la figure 6b le procédé de séparation laser thermique, dans lequel on vient d'abord réaliser des amorces A sur la face arrière AR, puis des amorces sur la face avant AV et enfin la séparation en face avant AV. Dans ce procédé de découpe, on ne réalise pas de découpe avec trait continu. L'amorce se propage en raison de contraintes thermomécaniques le long le d'une ligne.

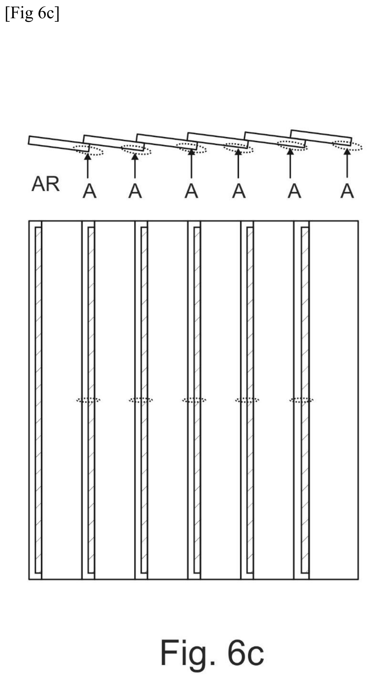

On a illustré à la figure 6c le procédé de découpe par clivage mécanique, dans lequel on vient d'abord réaliser des amorces A sur la face arrière AR, puis un clivage sur la face arrière AR. La séparation résulte des contraintes mécaniques exercées de chaque côté lors du clivage. L'amorce peut se propager du fait d'une orientation cristalline particulière dans l'assemblage.

L'étape de découpage (b) de l'assemblage en bandes de sous-cellules comporte l'application d'une contrainte, notamment une contrainte appliquée uniformément sur toute l'assemblage.

On a illustré aux figures 5a à 6c des exemples de réalisation non limitatifs d'amorces en fonction du procédé de découpe utilisé. Bien entendu, les amorces peuvent être réalisées différemment sans que l'on sorte du cadre de la présente invention. Les amorces peuvent être continues ou discontinues, et différentes sur les faces avant et arrière.

## Revendications

1. Procédé de fabrication d'une chaîne photovoltaïque, comportant les étapes suivantes :
(a) fournir un assemblage de sous-cellules (10) disposées en tuiles selon des lignes de tuilage (11) parallèles entre elles, les sous-cellules étant connectées entre elles en série,
(b) découper l'assemblage perpendiculairement aux lignes de tuilage (11) pour obtenir plusieurs bandes (20) de sous-cellules disposées en tuiles,
(c) connecter entre elles les bandes (20) de sous-cellules obtenues,
l'étape de découpage (b) de l'assemblage en bandes (20) de sous-cellules comportant la formation d'une amorce,
l'amorce étant réalisée sur une première portion de l'assemblage comportant une double épaisseur, résultant du tuilage des sous-cellules.

2. Procédé selon la revendication précédente, l'assemblage comportant plusieurs lignes conductrices d'interconnexion (12) parallèles entre elles, destinées à permettre la conduction d'un courant électrique photo-généré dans le matériau semi-conducteur, notamment chaque sous-cellule (10) comportant une ligne conductrice d'interconnexion (12) sur au moins une de ses faces.

3. Procédé selon la revendication précédente, chaque sous-cellule (10) comportant des doigts de métallisation (16), destinés à conduire le courant électrique photo-généré dans le matériau semi-conducteur vers une ligne conductrice d'interconnexion (12).

4. Procédé selon l'une quelconque des revendications précédentes, les sous-cellules (10) étant maintenues entre elles par collage, notamment par un adhésif conducteur d'électricité (dit ECA).

5. Procédé selon l'une quelconque des revendications précédentes, le découpage (b) de l'assemblage en bandes (20) de sous-cellules étant effectué par l'un au moins des procédés de découpe de la liste suivante : LSMC (Gravure laser et clivage mécanique, en anglais *'Laser scribe and mechanical cleaving'*), TLS (Séparation laser thermique, en anglais *'Thermal laser separation'*), découpe par clivage mécanique de plaquettes orientées à 45° (en anglais *'45° tilted silicon wafers'*).

6. Procédé selon l'une quelconque des revendications précédentes, l'amorce étant réalisée sur une deuxième portion de l'assemblage disposée à une extrémité de l'assemblage.

7. Procédé selon l'une quelconque des revendications précédentes, l'amorce (A) ayant une profondeur supérieure à 10 µm, voire supérieure à 20 µm, voire encore supérieure à 30 µm.

8. Procédé selon l'une quelconque des revendications précédentes, l'amorce (A) étant formée sur le bord d'une sous-cellule (10).

9. Procédé selon l'une quelconque des revendications précédentes, la ou les amorces (A) étant formées du côté de la face arrière (AR).

10. Procédé selon l'une quelconque des revendications précédentes, l'étape de découpage (b) de l'assemblage en bandes (20) de cellules comportant l'application d'une contrainte, notamment une contrainte appliquée uniformément sur tout l'assemblage.

11. Procédé selon l'une quelconque des revendications précédentes, un rapport P/S d'une sous-cellule (10) étant inférieur à 2 cm-1, voire inférieur à 1,8 cm-1, voire encore inférieur à 1,6 cm-1, mieux inférieur à 1,4 cm-1,
où P est le périmètre de la sous-cellule et S l'aire de la sous-cellule.
